(19)

Europäisches
Patentamt
European
Patent Office
Office européen
des brevets

(11) **EP 2 944 501 A2**

(12) **EUROPEAN PATENT APPLICATION**

(43) Date of publication:
**18.11.2015 Bulletin 2015/47**

(51) Int Cl.:
**B60L 3/00** *(2006.01)* **B60L 11/18** *(2006.01)*

(21) Application number: **15159002.3**

(22) Date of filing: **13.03.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **08.05.2014 KR 20140055067**

(71) Applicant: **Samsung SDI Co., Ltd.**
**Gyeonggi-do 446-902 (KR)**

(72) Inventors:
• **Ahn, Gi-Jang**
**446-902 Yongin-si, Gyeonggi-do (KR)**
• **Cheong, Kyeong-Beom**
**446-902 Yongin-si, Gyeonggi-do (KR)**

(74) Representative: **Gulde & Partner**
**Patent- und Rechtsanwaltskanzlei mbB**
**Wallstraße 58/59**
**10179 Berlin (DE)**

(54) **Battery management apparatus**

(57) A battery management apparatus (1) includes a sensing unit (20), a calculation unit (36), and a determination unit (38). The sensing unit (20) detects temperature and current of at least one battery cell (C) of a plurality of battery cells in a battery (10). The calculation unit (36) calculates a first degradation capacity (Qd) based on the detected temperature of the at least one battery cell at every unit time while the vehicle is being driven, and calculates a second degradation capacity (Qp) using the detected temperature and a state of charge (SOC) of the at least one battery cell (C) at every unit time while the vehicle is parked. The determination unit (38) determines a replacement time of the battery (10) by selecting one of the battery cells (C) which has a largest sum of the first and second degradation capacities (Qd, Qp), and then calculates a state of health (SOH) of the battery (10) depending on the first and second degradation capacities (Qd, Qp) of the selected one of the battery cells (C).

FIG. 3

Determine The Driving State of Vehicle — S310

Vehicle Moving / Vehicle Not Moving

S320 → Caclulate First Degradation Capacities $Q_d$ of Battery Cells

S330 → Caclulate Second Degradation Capacities $Q_p$ of Battery Cells

S340 — Calculate Overall Degradation Capacities of Battery Cells Based ON Respective ones of $Q_d$ and $Q_p$

S380 — Control Charging or Discharging of Battery Cells based ON Overall Degradation Capacities

S350 — Select one of The Battery Cells having a Predetermined Overall Degradation Capacity

S360 — Determine Overall State of Health of The Battery Based ON Overall Degradation Capacity of Selected Cell

S370 — Determine Replacement Time of Battery Based ON Overall State of Health of Battery

EP 2 944 501 A2

**Description**

BACKGROUND

1. Field

One or more embodiments herein relate to a battery management apparatus.

2. Description of the Related Art

Vehicles which use gasoline or diesel fuel cause environmental pollution. In effort to reduce pollution, electric and hybrid vehicles have been developed. These vehicles are powered, at least in part, from electrical energy output from a battery.

SUMMARY

In accordance with one embodiment, a battery management apparatus for managing a battery disposed in a vehicle and which includes at least one battery module having a plurality of battery cells includes a sensing unit to detect temperature and current of at least one battery cell of the plurality of battery cells; a calculation unit to calculate a first degradation capacity based on the detected temperature of the at least one battery cell at every unit time while the vehicle is being driven and to calculate a second degradation capacity using the detected temperature and a state of charge (SOC) of the at least one battery cell at every unit time while the vehicle is parked; and a determination unit to determine a replacement time of the battery by selecting one of the battery cells which has a largest sum of the first and second degradation capacities, and then calculating a state of health (SOH) of the battery depending on the first and second degradation capacities of the selected one of the battery cells.

The sensing unit may include at least one temperature sensor and at least one current sensor provided for each of the battery cells. The sensing unit may include a first temperature sensor and a current sensor in a first battery cell, where a highest temperature region is present inside of the battery, and a second temperature sensor and a second current sensor in a second battery cell, where a lowest temperature region is present inside of the battery.

The calculator may calculate the first degradation capacity based on the following equation:

$$Qd[i]=Bd\times e^{-\frac{Ea}{R\times Tb[i]}}\times t^{n}\times g(Tb[i])$$

where Qd[i] is the first degradation capacity of an i-th battery cell Ci among battery cells C1 to Cn, Tb[i] is a temperature of an i-th battery cell among the battery cells C1 to Cn, Bd denotes a slope of a function showing a degradation degree of a standard capacity of the battery according to varying temperatures of the battery, Ea is activation energy corresponding to a current temperature of the battery, R is a gas constant, t is time, and n is a constant that is predetermined by a degradation speed of the battery according to the time.

The calculation unit may calculate the second degradation capacity according to the following equation:

$$Qp[i]=Bp\times e^{-\frac{Ea}{R\times Tb[i]}}\times t^{n}\times g(Tb[i])$$

where Qp[i] is the second degradation capacity of the i-th battery cell Ci among battery cells C1 to Cn, Tb[i] is a temperature of the i-th battery cell among the battery cells C1 to Cn, Bp denotes a slope of a function that is calculated by using the idle SOC in which a total amount of current for the i-th battery cell Ci is accumulated, Ea is activation energy corresponding to a current temperature of the battery, R is a gas constant, t is time, and n is a constant that is predetermined by a degradation speed of the battery according to time.

The calculation unit may calculate the SOC based on a total accumulated amount of current flowing through at least one of the battery cells. The calculation unit may calculate the first and second degradation capacities based on a standard capacity of the battery.

In accordance with another embodiment, a battery management system includes a calculation unit to calculate first degradation capacities of respective ones of a plurality of battery cells of a battery while a vehicle is in a first state, and to calculate second degradation capacities of respective ones of the battery cells of the battery while the vehicle is in a second state; and a determination unit to determine overall degradation capacities of the battery cells based on corresponding ones of the first and second degradation capacities, and to control charging or discharging of the battery cells based on the overall degradation capacities of corresponding ones of the battery cells.

The first state may correspond to when the vehicle is moving, and the second state may correspond to when the vehicle has not moved for at least a predetermined period of time.

The determination unit may determine an overall state of health of the battery based on an overall degradation capacity of one battery cell of the battery cells, the overall degradation capacity of the one battery cell may be determined based on the first and second degradation capacities of the one battery cell. The one battery cell may have a highest overall degradation capacity of the battery cells. The determination unit may determine a replacement time of the battery based on the overall state of health of the battery.

The determination unit may determine the replacement time in accordance with operations that include calculating a remaining period after which the state of health of the battery falls below a predetermined reference value, and determining the replacement time based on the remaining period. The determination unit may output information to be display indicative of the replacement time.

The calculation unit may calculate the first degradation capacities based on respective temperatures of the battery cells while the vehicle is in the first state, and the second degradation capacities based on respective temperatures of battery cells and a state of charge of the battery while the vehicle is in the second state.

In accordance with one embodiment, a battery management system includes a calculation unit to calculate first degradation capacities of first and second battery cells of a plurality of battery cells of a battery while a vehicle is in a first state, and to calculate second degradation capacities of the first and second battery cells of the battery while the vehicle is in a second state; and a determination unit to determine an overall degradation capacity of the battery based on one of a first sum of the first and second degradation capacities of the first battery cell or a second sum of the first and second degradation capacities of the second battery cell, the determination unit to determine a replacement time of the battery based on the overall degradation capacity of the battery.

The first battery cell may correspond to at a first predetermined position relative to a fan of the vehicle, and the second battery cell may correspond to a second predetermined position relative to the fan of the vehicle. The first predetermined position may be farthest from the fan, and the second predetermined position may be closest to the fan.

The first state may correspond to when the vehicle is moving, and the second state may correspond to when the vehicle has not moved for at least a predetermined period of time. The first and second degradation capacities may be based on at least one of temperatures or currents of the first and second battery cells, respectively.

BRIEF DESCRIPTION OF THE DRAWINGS

Features will become apparent to those of skill in the art by describing in detail exemplary embodiments with reference to the attached drawings in which:

FIG. 1 illustrates an embodiment of a battery management apparatus;
FIG. 2 illustrates an embodiment of a battery management unit;
FIG. 3 illustrates an embodiment of a method for managing a battery;
FIG. 4 illustrates another embodiment of a battery management apparatus; and
FIG. 5 illustrates another embodiment of a method for managing a battery.

DETAILED DESCRIPTION

Example embodiments are described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. Throughout this specification, when it is described that an element is "coupled" to another element, the element may be "directly coupled" to the other element or "electrically coupled" to the other element through a third element.

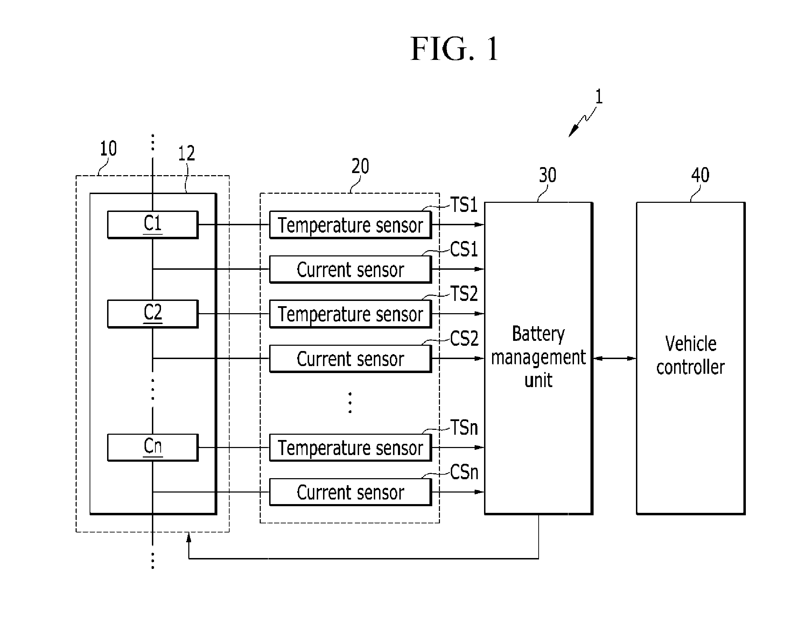

FIG. 1 illustrates an embodiment of a battery management apparatus 1 which includes a battery 10, a sensing unit (e.g., a sensor) 20, a battery management unit 30, and a vehicle controller 40. The battery 10 includes at least one battery module 12. The battery module 12 includes a plurality of battery cells C1 to Cn electrically connected to each other. The plurality of battery cells C1 to Cn may be connected to each other in series or parallel.

The sensing unit 20 includes a plurality of temperature sensors TS1 to TSn and a plurality of current sensors CS1 to CSn. The temperature sensors TS1 to TSn detect temperatures of the corresponding battery cells C1 to Cn. The current sensors CS1 to CSn detect currents of the corresponding battery cells C1 to Cn.

The battery management unit 30 communicates with the vehicle controller 40 to receive information indicative of a driving state of a host vehicle, and receives information about respective temperatures and currents of the battery cells C1 to Cn from the sensing unit 20. The battery management unit 30 estimates an overall state of health (SOH) of the battery 10 based on the driving state of the vehicle and the respective temperatures and currents of the battery cells C1 to Cn.

The battery management unit 30 also determines a replacement time of the battery 10 and outputs information indicative of the replacement time based on the estimated overall SOH of the battery. The information may be output, for example, on a display readable by a user.

For example, while the vehicle containing the battery management system is being driven, the battery management unit 30 may use the temperature information of the battery 10 to calculate the degradation capacity Qd of each of the battery cells C1 to Cn at every unit time. Qd may be referred to as a first degradation capacity.

The battery management unit 30 may use the temperature information and an idle state of charge (SOC) of the battery 10 while the vehicle is parked to calculate the degradation capacity Qp of each of the battery cells C1 to Cn at every unit time. Qp may be referred to as a second degradation capacity. While the vehicle is parked, the temperature of the battery 10 may respond to or be affected by an ambient temperature of the battery 10, e.g., external temperature outside of the vehicle. Throughout this invention, the term "parked" refers to a situation where the vehicle is not in motion, e.g., for a predetermined period of time.

The battery management unit 30 estimates the overall SOH of the battery 10 based on a sum of the calculated first and second degradation capacities Qd and Qp. The battery management unit 30 selects one battery cell of the battery cells C1 to Cn, which has a predetermined sum of the first and second degradation capacities Qd and Qp, and then estimates the overall SOH of the battery 10 based on the sum of the first and second degradation capacities Qd and Qp. For example, the battery management unit 30 determines the overall SOH of the battery 10 based on one battery cell with highest degree of degradation among the battery cells C1 to Cn. The predetermined sum may be, for example, the largest sum of the first and second degradation capacities, or another sum.

In a battery pack including a battery module 12 or a plurality of battery modules 12, battery capacity may decrease as a result of a plurality of factors, including, for example, degradation of the battery cells and temperature drop. This is because, among the battery cells C1 to Cn, the lowest capacity battery cell (e.g., the battery cell with a quickest voltage drop at discharging) may determine the battery capacity of the battery module 12 or the battery pack.

Thus, the battery management unit 30 may determine the overall SOH based on the temperature of the battery 10 while the vehicle is being driven, and the ambient temperature of the battery 10 and the first and second degradation capacities Qd and Qp of the lowest capacity battery cell while the vehicle is parked or when the vehicle otherwise comes to a stop, e.g., for a predetermined period of time.

In addition, the battery management unit 30 may balance charging states of the battery cells C1 to Cn depending on the first and second degradation capacities Qd and Qp of respective ones of the battery cells C1 to Cn.

The vehicle controller 40 determines the current driving state of the vehicle, for example, based on information from the accelerator, brake, and/or a speed of the vehicle, and then controls driving of a motor based on the driving state of the vehicle. The driving state of the vehicle may include, for example, a key-on state for turning on the engine, a key-off state for turning off the engine, a cruise driving state, an acceleration driving state, and/or other states.

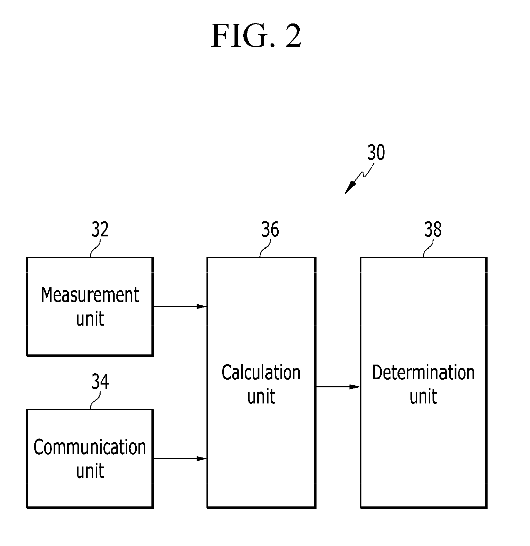

FIG. 2 illustrates an embodiment of battery management unit, which, for example, may correspond to battery management unit 30 in FIG. 1. Referring to FIG. 2, the battery management unit 30 includes a measurement unit 32, a communication unit 34, a calculation unit (e.g., calculation unit) 36, and a determination unit 38.

The measurement unit 32 measures the temperature and current of respective ones of the battery cells C1 to Cn at every predetermined unit of time using the sensing unit 20. The temperature and current information is then transmitted to the calculation unit 36.

The communication unit 34 communicates with the vehicle controller 40 and receives the information about the driving state of the vehicle for transmit to the calculation unit 36. The calculation unit 36 determines whether the vehicle is being driven or parked (or otherwise stopped) based on the information about the driving state of the vehicle. Also, the calculation unit 36 may calculate the first degradation capacities Qd of respective ones of the battery cells C1 to Cn based on the Equation 1 while the vehicle is being driven.

$$Qd[i]=Bd \times e^{-\frac{Ea}{R \times Tb[i]}} \times t^n \times g(Tb[i])$$

(1)

Here, Qd[i] is the first degradation capacity of an i-th battery cell Ci among the battery cells C1 to Cn, and Tb[i] is temperature of the i-th battery cell among the battery cells C1 to Cn.

Bd and Ea are values that may be pre-calculated by testing of at least one battery cell and using measured values of a standard discharge capacity of the battery cell having a standard discharge capacity. For example, a total amount of current is accumulated to be measured while the battery cell is discharged from 4.1 V to 2.7 V at 1/3 C. Bd and Ea are then set based on the measured value of the standard discharge capacity of the battery cell during this time.

For example, Bd denotes a slope corresponding to a current temperature of the i-th battery cell Ci in a function that shows, based on the measured value of the standard discharge capacity of the battery cell, varying degradation capacities according to varying temperatures. Ea denotes activation energy corresponding to a current temperature of the i-th battery cell Ci. R is a gas constant, t is time, and n is a predetermined constant that allows for a slowed degradation process of the battery cell as time passes. Also, g(Tb[i]) denotes the amount of capacity variation according to the temperature of the i-th battery cell Ci.

While the vehicle is parked (or otherwise is not in motion, e.g., for a predetermined period of time), the calculation unit 36 may calculate the respective second degradation capacities Qp of the battery cells C1 to Cn according to Equation 2.

$$Qp[i]=Bp \times e^{-\frac{Ea}{R \times Tb[i]}} \times t^n \times g(Tb[i])$$

(2)

Here, Qp[i] is the second degradation capacity of the i-th battery cell Ci among the battery cells C1 to Cn. Bp denotes a slope of a function calculated using the idle SOC in which a total amount of current for the i-th battery cell Ci is accumulated. For example, the idle SOC may refer to the remaining capacity of the i-th battery cell Ci when the vehicle is in an idle state due to parking. The predetermined period of time may be, for example, when the vehicle is idling, stopped at a stop light or stop sign, or in gear but not in motion.

The determination unit 38 may be a processor which adds the respective first and second degradation capacities Qd and Qp of the battery cells C1 to Cn to calculate the overall SOH. The determination unit 38 also selects one battery cell having the highest overall degradation capacity among the battery cells C1 to Cn. The determination unit 38 also estimates the overall SOH of the battery 10 depending on the overall degradation capacity of the selected battery cell.

Further, the determination unit 38 determines a replacement time of the battery 10 in real time depending on the overall SOH, and notifies a user of the replacement time of the battery 10. For example, the determination unit 38 may calculate a remaining period after which the SOH of the battery 10 falls below a predetermined reference value under the assumption that the current driven state or parked state of the vehicle is continuously maintained, and may determine the corresponding remaining period until the battery 10 should be replaced.

Further, the determination unit 38 may control charging and discharging of each of the battery cells C1 to Cn depending on the respective overall degradation capacities of the battery cells C1 to Cn.

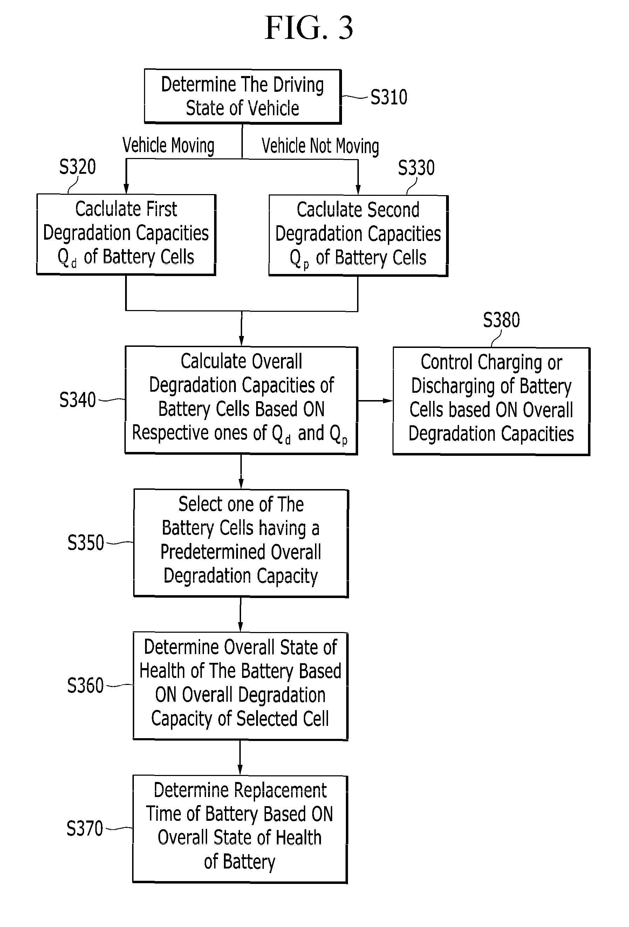

FIG. 3 illustrates one embodiment of a method for managing a battery including a plurality of battery cells. The battery may be included in a vehicle as previously described or may be used in another power application. For illustrative purposes, the following description is provided for a vehicle application.

An initial operation includes determining the driving state of the vehicle (S310). The vehicle may be in a moving state (e.g., driving state) or may be in a state where the vehicle is not moving (e.g., parked, idle, stopped while in drive, etc.).

When the vehicle is in a moving state, first degradation capacities $Q_d$ of the battery cells are calculated (S320). The first degradation capacities may be calculated in accordance with any of the aforementioned embodiments. When the vehicle is not moving, second degradation capacities $Q_p$ of the battery cells may be calculated (S330). The second degradation capacities may be calculated in accordance with any of the aforementioned embodiments.

In a subsequent operation, overall degradation capacities of the battery cells are calculated based on the first and second degradation capacities of respective ones of the battery cells (S340). The overall degradation capacities may be calculated in accordance with any of the aforementioned embodiments.

One of the battery cells having a predetermined overall degradation capacity is then selected (S350). This battery cell may be selected as previously explained. Then, the overall state of health of the battery may be determined based on the overall degradation capacity of the selected battery cell (S360). A replacement time for the battery may be determined based on the overall state of health of the battery (S370).

Additionally, control of the charging and/or discharging of the battery cells may be performed based on the overall degradation capacities of respective ones of the battery cells (S380), as previously indicated.

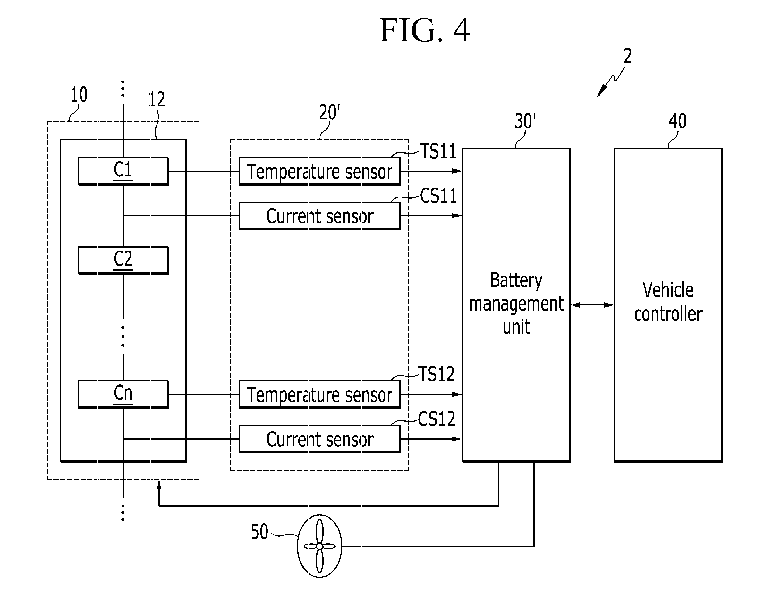

FIG. 4 illustrates another embodiment of a battery management apparatus 2 which includes a battery 10, a sensing unit 20', a battery management unit 30', a vehicle controller 40, and a cooling fan 50. The battery 10 and the vehicle controller 40 may have the same configuration as in FIG. 1, or another configuration.

The sensing unit 20' includes a first temperature sensor TS11, a second temperature sensor TS12, a first current sensor CS11, and a second current sensor CS12. The first temperature sensor TS11 detects a temperature of the first battery cell C1, where a highest temperature region is present inside of the battery 10, among the battery cells C1 to Cn.

The second temperature sensor TS12 detects a temperature of the n-th battery cell Cn, located where a lowest temperature region is present inside of the battery 10, among the battery cells C1 to Cn. Further, the first current sensor CS11 detects a current flowing through the first battery cell C1. The second current sensor CS12 detects a current flowing through the n-th battery cell Cn.

The highest temperature region inside battery 10 may be a first predetermined region relative to the cooling fan 50, and the lowest temperature region inside the battery 10 may be a second predetermined region relative to the cooling fan 50. For example, the first predetermined region may be farthest from the cooling fan 50, and the second predetermined region may be closest to the cooling fan 50. In another implementation, the first and second predetermined regions may be locations that are not based on the location of a cooling fan, e.g., a particular location in a battery module.

In one embodiment, the first temperature sensor TS11, the second temperature sensor TS12, the first current sensor CS11, and the second current sensor CS12 may be differently positioned according to an internal environment of the vehicle.

The battery management unit 30' estimates an overall SOH of the battery 10 based on the driving state of the vehicle and the respective temperatures and currents of the first and the n-th battery cells C1 and Cn. For example, the battery management unit 30' calculates the respective first degradation capacities Qd of the first and n-th battery cells C1 and Cn according to Equation 1 at every unit time while the vehicle is driven.

Further, the battery management unit 30' calculates the respective second degradation capacities Qp of the first and n-th battery cells C1 and Cn, for example, according to Equation 2, at every unit time while the vehicle is parked or otherwise is not in motion for a predetermined period of time.

The battery management unit 30' estimates the overall SOH of the battery 10 depending on a predetermined one (e.g., the largest one) of the sums of the first and second degradation capacities Qd and Qp of respective ones of the first and n-th battery cells C1 and Cn.

The battery management unit 30' determines a replacement time of the battery 10 based on the estimated overall SOH, and notifies a user of the replacement time.

The cooling fan 50 reduces heat generated from charging and discharging the battery 10. The present embodiment is therefore different from the embodiment of FIG. 1 in that it uses the temperatures and the idle SOCs of the first and n-th battery cells C1 and Cn, which are the most sensitive of the battery cells C1 to Cn, to calculate the first and second degradation capacities Qd and Qp. A design margin thus may be attained.

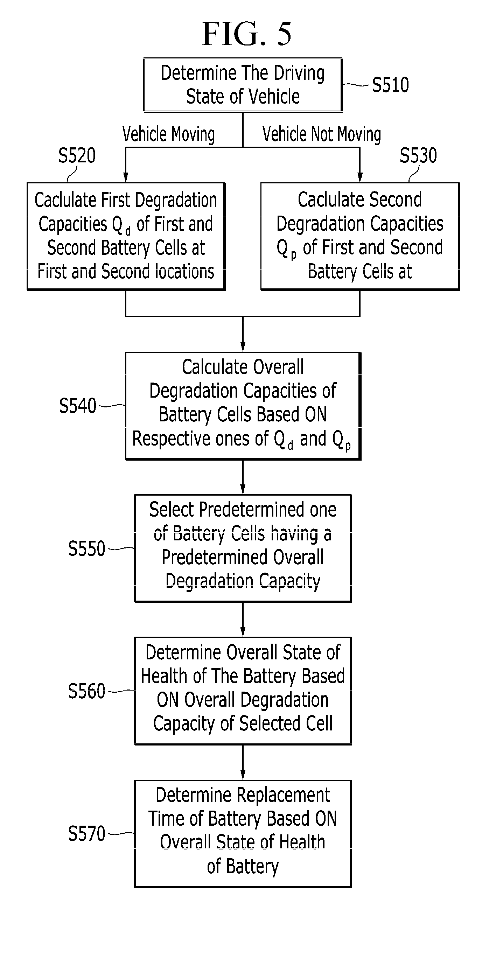

FIG. 5 illustrates another embodiment of a method for managing a battery including a plurality of battery cells. The battery may be included in a vehicle as previously described or may be used in another power application. For illustrative purposes, the following description is provided for a vehicle application.

An initial operation includes determining the driving state of the vehicle (S510). The vehicle may be in a moving state (e.g., driving state) or may be in a state where the vehicle is not moving (e.g., parked, idle, stopped while in drive, etc.).

When the vehicle is in a moving state, first degradation capacities $Q_d$ of first and second battery cells at respective first and second locations are calculated (S520). The first degradation capacities may be calculated in accordance with any of the aforementioned embodiments. The first and second locations may be ones farthest away from and closest to a cooling fan of the vehicle, or vice versa, or other predetermined locations.

When the vehicle is not moving, second degradation capacities $Q_p$ of the first and second battery cells may be calculated (S530). The second degradation capacities may be calculated in accordance with any of the aforementioned embodiments.

In a subsequent operation, overall degradation capacities of the first and second battery cells are calculated based on the first and second degradation capacities of respective ones of the first and second battery cells (S540). The overall degradation capacities may be calculated in accordance with any of the aforementioned embodiments.

One of the first or second battery cells having a predetermined overall degradation capacity is then selected (S550). This battery cell may be selected as previously explained. Then, the overall state of health of the battery may be determined based on the overall degradation capacity of the selected battery cell (S560). A replacement time for the battery may be determined based on the overall state of health of the battery (S570).

The methods, processes, and/or operations described herein may be performed by code or instructions to be executed by a computer, processor, controller, calculation unit, or other signal processing device. The computer, processor, controller, calculation unit, or other signal processing device may be those described herein or one in addition to the elements described herein. Because the algorithms that form the basis of the methods (or operations of the computer, processor, controller, or other signal processing device) are described in detail, the code or instructions for implementing the operations of the method embodiments may transform the computer, processor, controller, or other signal processing device into a special-purpose processor for performing the methods described herein.

Also, another embodiment may include a computer-readable medium, e.g., a non-transitory computer-readable medium, for storing the code or instructions described above. The computer-readable medium may be a volatile or non-volatile memory or other storage device, which may be removably or fixedly coupled to the computer, processor, controller, or other signal processing device which is to execute the code or instructions for performing the method embodiments described herein.

By way of summation and review, because battery performance affects vehicle performance, battery management systems have been developed to monitor battery operation. These systems estimate the battery parameters (e.g., state of charge, state of health), and then attempt to efficiently manage charging/discharging and the useful lifespan of a battery based on these parameters. In accordance with one or more of the aforementioned embodiments, a battery management apparatus calculates a state of health (SOH) of a battery to estimate a lifespan of the battery while a vehicle is driven or parked.

Example embodiments have been disclosed herein, and although specific terms are employed, they are used and are to be interpreted in a generic and descriptive sense only and not for purpose of limitation. In some instances, as would be apparent to one of skill in the art as of the filing of the present application, features, characteristics, and/or elements described in connection with a particular embodiment may be used singly or in combination with features, characteristics, and/or elements described in connection with other embodiments unless otherwise indicated. Accordingly, it will be understood by those of skill in the art that various changes in form and details may be made without departing from the scope of the present invention as set forth in the following claims.

**Claims**

1. A battery management apparatus (1) for managing a battery (10) which is disposed in a vehicle and which includes at least one battery module (12) having a plurality of battery cells (C), the apparatus comprising:

   a sensing unit (20) adapted to detect temperature and current of at least one battery cell (C) of the plurality of battery cells;
   a calculation unit (36) configured to calculate a first degradation capacity (Qd) based on the detected temperature (Tb) of the at least one battery cell (C) at every unit time while the vehicle is being driven and to calculate a second degradation capacity (Qp) using the detected temperature (Tb) and a state of charge (SOC) of the at least one battery cell (C) at every unit time while the vehicle is parked; and
   a determination unit (38) to determine a replacement time of the battery (10) by selecting one of the battery cells (C) which has a largest sum of the first and second degradation capacities (Qd, Qp), and then calculating a state of health (SOH) of the battery (10) depending on the first and second degradation capacities (Qd, Qp) of the selected one of the battery cells (C).

2. The apparatus as claimed in claim 1, wherein the sensing unit (20) includes:

   at least one temperature sensor (TS) and at least one current sensor (CS) provided for each of the battery cells (C).

3. The apparatus (1) as claimed in claim 1, wherein the sensing unit (20) includes:

   a first temperature sensor (TS) and a current sensor (CS) in a first battery cell (C), the first battery cell (C) being lcoated where a highest temperature region is present inside of the battery (10), and
   a second temperature sensor (TS) and a second current sensor (CS) in a second battery cell (C), the second battery cell being located where a lowest temperature region is present inside of the battery (10).

4. The apparatus (1) as claimed in one of the previous claims, wherein the calculation unit (36) is configured to calculate the first degradation capacity (Qd) based on the following equation:

$$Qd[i] = Bd \times e^{-\frac{Ea}{R \times Tb[i]}} \times t^n \times g(Tb[i])$$

where Qd[i] is the first degradation capacity of an i-th battery cell Ci among battery cells C1 to Cn, Tb[i] is a temperature of an i-th battery cell among the battery cells C1 to Cn, Bd denotes a slope of a function showing a degradation degree of a standard capacity of the battery according to varying temperatures of the battery, Ea is activation energy corresponding to a current temperature of the battery (10), R is a gas constant, t is time, and n is a constant that is predetermined by a degradation speed of the battery (10) according to the time.

5. The apparatus (1) as claimed in one of the previous claims, wherein the calculation unit (36) is configured to calculate the second degradation capacity (Qp) according to the following equation:

$$Qp[i] = Bp \times e^{-\frac{Ea}{R \times Tb[i]}} \times t^n \times g(Tb[i])$$

where Qp[i] is the second degradation capacity of the i-th battery cell Ci among battery cells C1 to Cn, Tb[i] is a temperature of the i-th battery cell among the battery cells C1 to Cn, Bp denotes a slope of a function that is calculated by using the parked SOC in which a total amount of current for the i-th battery cell Ci is accumulated, Ea is activation energy corresponding to a current temperature of the battery (10), R is a gas constant, t is time, and n is a constant that is predetermined by a degradation speed of the battery (10) according to time.

6. The apparatus (1) as claimed in one of the previous claims, wherein the calculation unit (36) is configured to calculate the state of charge (SOC) based on a total accumulated amount of current flowing through at least one of the battery cells (C).

7. The apparatus (1) as claimed in claim 1, wherein the calculation unit (36) is configured to calculate the first and second degradation capacities (Qd, Qp) based on a standard capacity of the battery (10).

8. The apparatus (1) as claimed in one of the previous claims, wherein the determination unit (38) is to determine the replacement time in accordance with operations that include:

    calculating a remaining period after which the state of health (SOH) of the battery falls below a predetermined reference value, and
    determining the replacement time based on the remaining period.

9. The apparatus (1) as claimed in one of the previous claims, wherein the determination unit (38) is configured to output information to be displayed indicative of the replacement time.

10. An apparatus (1) of one of the previous claims wherein
    the calculation unit is configured to calculate first and second degradation capacities (Qd, Qp) of first and second battery cells of a plurality of battery cells (C) of a battery (10); and
    the determination unit (38) is configured to determine an overall degradation capacity of the battery (10) based on one of a first sum of the first and second degradation (Qd, Qp) capacities of the first battery cell or a second sum of the first and second degradation capacities (Qd, Qp) of the second battery cell, and to determine a replacement time of the battery (10) based on the overall degradation capacity of the battery (10).

11. The apparatus (1) as claimed in claim 10, wherein:

    the first battery cell corresponds to a first predetermined position relative to a fan (50) of the vehicle, and
    the second battery cell corresponds to a second predetermined position relative to the fan (50) of the battery.

**12.** The apparatus (1) as claimed in claim 11, wherein:

the first predetermined position is farthest from the fan (50), and
the second predetermined position is closest to the fan (50).

**13.** The apparatus (1) as claimed in one of the previous claims, further comprising a measurement unit (32) adapted to measure the temperature and current of respective ones of the battery cells (C) at every predetermined unit of time using the sensing unit (20).

**14.** The apparatus (1) as claimed in one of the previous claims, further comprising a communication unit (34) configured to communicate with a vehicle controller (40) and to receive information about a driving state of the vehicle for transmittance to the calculation unit (36).

**15.** The apparatus (1) as claimed in claim 14, wherein the calculation unit (36) determines whether the vehicle is being driven or parked based on the information about the driving state of the vehicle.

# FIG. 1

# FIG. 2

# FIG. 3

Determine The Driving State of Vehicle — S310

Vehicle Moving | Vehicle Not Moving

S320

Caclulate First Degradation Capacities $Q_d$ of Battery Cells

S330

Caclulate Second Degradation Capacities $Q_p$ of Battery Cells

S340 — Calculate Overall Degradation Capacities of Battery Cells Based ON Respective ones of $Q_d$ and $Q_p$

S380

Control Charging or Discharging of Battery Cells based ON Overall Degradation Capacities

S350 — Select one of The Battery Cells having a Predetermined Overall Degradation Capacity

S360 — Determine Overall State of Health of The Battery Based ON Overall Degradation Capacity of Selected Cell

S370 — Determine Replacement Time of Battery Based ON Overall State of Health of Battery

# FIG. 4

# FIG. 5

Determine The Driving
State of Vehicle — S510

Vehicle Moving | Vehicle Not Moving

S520

Caclulate First Degradation
Capacities $Q_d$ of First and
Second Battery Cells at
First and Second locations

S530

Caclulate Second
Degradation Capacities
$Q_p$ of First and Second
Battery Cells at

S540 — Calculate Overall
Degradation Capacities of
Battery Cells Based ON
Respective ones of $Q_d$ and $Q_p$

S550 — Select Predetermined one
of Battery Cells having a
Predetermined Overall
Degradation Capacity

S560 — Determine Overall State of
Health of The Battery Based
ON Overall Degradation
Capacity of Selected Cell

S570 — Determine Replacement
Time of Battery Based ON
Overall State of Health
of Battery